# EUROPEAN PATENT SPECIFICATION

(11) **EP 4 040 080 B1**
(45) Date of publication and mention of the grant of the patent: **03.04.2024**
(21) Application number: 21155923.2
(22) Date of filing: 09.02.2021
(51) Int. Cl.: F25B 21/04, F25B 49/00, H10N 10/13, H10N 10/17

(54) **APPARATUS FOR HEATING A FLUID USING THERMOELECTRIC ASSEMBLIES**
VORRICHTUNG ZUR ERWÄRMUNG EINES FLUIDS UNTER VERWENDUNG THERMOELEKTRISCHER ANORDNUNGEN
APPAREIL DE CHAUFFAGE D'UN FLUIDE À L'AIDE D'ENSEMBLES THERMOÉLECTRIQUES

(43) Date of publication of application: 10.08.2022
(73) Proprietor: Ecodynamisch Management B.V., 6374 LL Landgraaf (NL)
(72) Inventor: LOUPPEN, Gerard Joseph, 6374 LL Landgraaf (NL); MAAT, Jan Johannes Adrianus, 2991DK Barendrecht (NL)
(74) Representative: Nederlandsch Octrooibureau

(56) References cited:
- WO-A1-2010/088433
- WO-A1-2020/086694
- US-A1- 2012 312 030

## Description

### Field of the invention

The present invention relates to an apparatus for heating a fluid using thermoelectric assemblies, e.g. useable in a central heating system and/or a hot tap water supply system.

### Background art

US patent publication US2018/0080689 discloses thermoelectric heat pump systems, especially suited for use in a container for storing or transporting temperature sensitive goods. A stack of Peltier elements is in thermal connection with a capacitance spacer block (used as heat sink) and controls temperature of a storage area.

US patent publication US2006/0048519 discloses a portable thermoelectric cooling and heating device comprising an array of thermoelectric units, a driving fan, a cold sink, a hot sink, air baffles and a cooling fan, wherein the driving fan creates a pressure gradient to pull air through channels in the center of the cold sink. the cooling fan pulls air through an arrangement of baffles connected to the hot sink. Depending on the direction of current to the thermoelectric units chilled or hot air is provided during operation. This publication discloses examples of operating a thermoelectric unit to obtain a temperature difference between the hot and cold side of the thermoelectric unit of more than 140°F (i.e. a temperature difference of 78°C or 78°K).

Moreover, US patent application US 2012/312030 discloses an apparatus according to the preamble of claim 1.

### Summary of the invention

The present invention seeks to provide an apparatus for heating a fluid with a high efficiency, especially when used to heat up water in a fluid circuit of a central heating system or a hot tap water supply system.

According to the present invention, an apparatus as defined in claim 1 is provided, comprising a fluid inlet and a fluid outlet, a converter block having a fluid channel arrangement in fluid communication with the fluid inlet and the fluid outlet, the converter block comprising a plurality of *n* contact surfaces, a plurality of *n* thermoelectric assemblies, each of the plurality of *n* thermoelectric assemblies being in thermal contact with an associated one of the plurality of *n* contact surfaces, and a plurality of *n* heat sink elements, each of the plurality of *n* heat sink elements being in thermal contact with an associated one of the plurality of *n* thermoelectric assemblies. Each thermoelectric assembly comprises a stack of m thermoelectric heat transfer elements, m being equal to two or more. The apparatus further comprises a control unit for providing current control to the plurality of *n* thermoelectric assemblies, wherein thermoelectric heat transfer elements in a corresponding layer in the stacks of the n thermoelectric assemblies are series connected, and the control unit is arranged to provide a current control to each of the series connected thermoelectric heat transfer elements to obtain a predetermined temperature difference for each of the layers in the stacks of the *n* thermoelectric assemblies.

By controlling the current supply to the thermoelectric heat transfer elements layer by layer using the control unit, a very effective heat exchange can be accomplished in the n stacks from the heat sink elements to the converter block and to a fluid flowing in the channel assembly by optimizing the current to each group of thermoelectric heat transfer elements. The coefficient of performance of exemplary implementations of the apparatus has proven to be very high.

### Short description of drawings

The present invention will be discussed in more detail below, with reference to the attached drawings, in which
Fig. 1 shows a perspective view of an apparatus according to an embodiment of the present invention;
Fig. 2 shows a side view of the apparatus shown in Fig. 1;
Fig. 3 shows a top view of the apparatus of Fig. 1;
Fig. 4 shows a cross sectional view along the lines IV-IV in Fig. 2;
Fig. 5 shows a cross sectional view along the lines V-V in Fig. 2;
Fig. 6A and 6B show a perspective top and bottom view, respectively, of a converter block half of an apparatus according to an embodiment of the present invention;
Fig. 7 shows a schematic diagram of a control unit of an apparatus according to a further embodiment of the present invention; and
Fig. 8 shows a schematic diagram of stacked and series connected Peltier elements as part of an apparatus according to an even further embodiment of the present invention.

### Description of embodiments

The present invention embodiments provide for an efficient apparatus for providing heat transfer to a fluid, which can be used e.g. for a central heating system or a hot water supply. The present invention embodiments use a combination of components which obviate any moving parts or other components which are susceptible to wear or degradation over time. This allows to provide a heating/cooling system for a house, optionally also providing (hot) tap water, which is environmentally friendly, energy efficient, silent during operation, and easy to maintain.

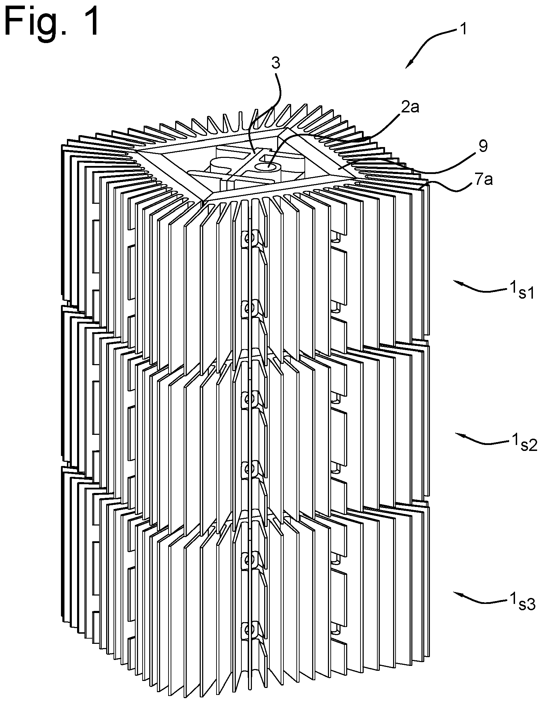

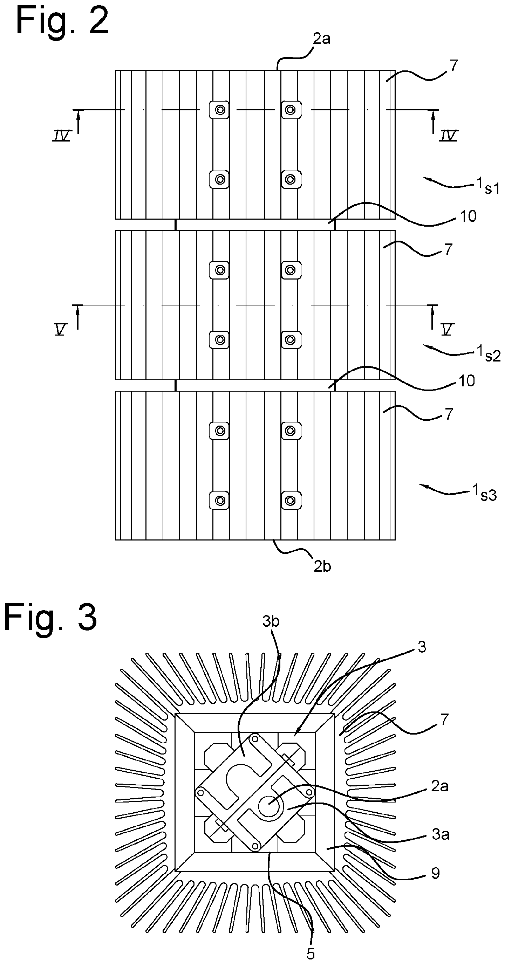

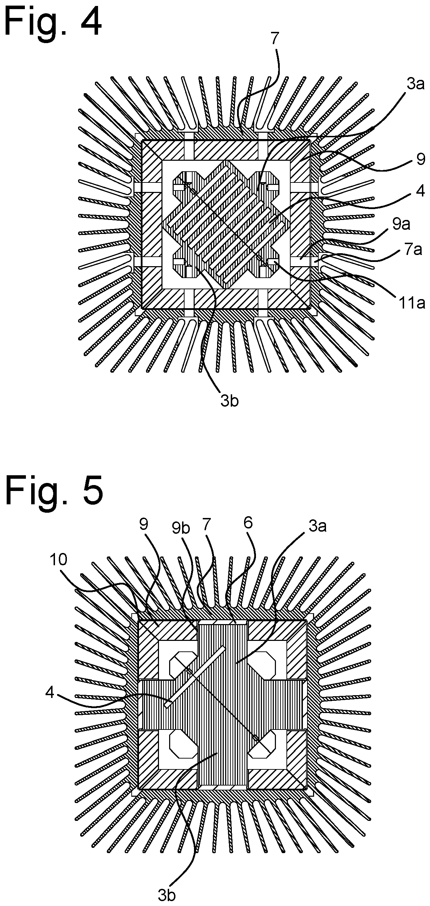

An exemplary embodiment of the present invention apparatus 1 is shown in perspective view in Fig. 1. Fig. 2 shows a side view of the apparatus and Fig. 3 shows a top view of the apparatus of Fig. 1. Fig. 4 shows a cross sectional view along the lines IV-IV in Fig. 2 and Fig. 5 shows a cross sectional view along the lines V-V in Fig. 2.

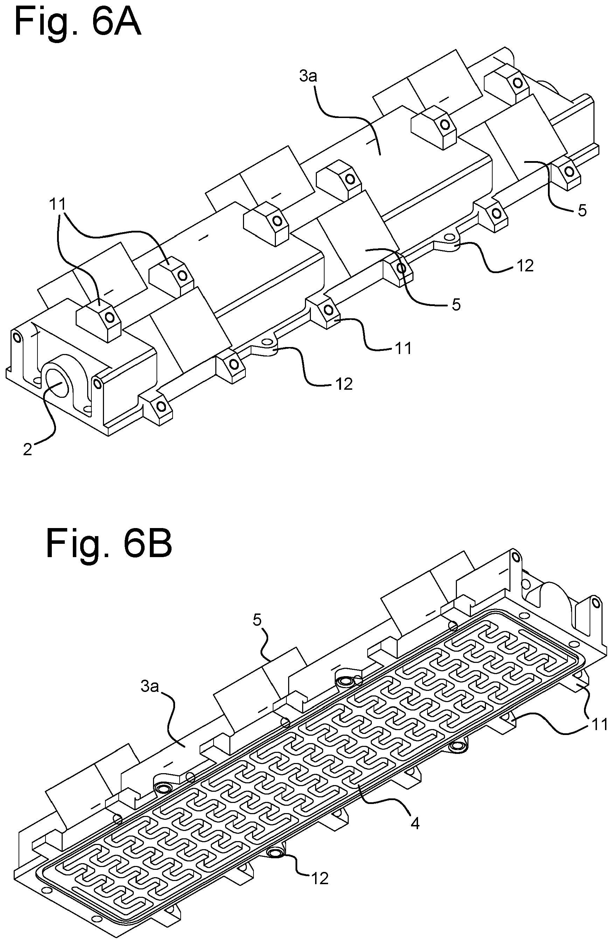

The apparatus 1 for transferring thermal energy to a fluid comprises a fluid inlet 2a (visible in Fig. 1 and 3) and a fluid outlet 2b (indicated at the bottom of Fig. 2). The fluid inlet 2a and fluid outlet 2b are positioned on opposite ends of a converter block 3 having a fluid channel arrangement 4 in fluid communication with the fluid inlet 2a and the fluid outlet 2b. The fluid channel arrangement 4 is visible in the cross sectional views of Fig. 4 and 5. The converter block 3 comprising a plurality of *n* contact surfaces 5 (*n* being an integer number), as will be explained below in more detail with reference to Fig. 6A and 6B. A plurality of n thermoelectric assemblies 6 are provided, each of the plurality of *n* thermoelectric assemblies 6 being in thermal contact with an associated one of the plurality of *n* contact surfaces 5. Note that in Fig. 1-5 the thermoelectric assemblies 6 are only visible in the cross sectional view of Fig. 5. Furthermore, a plurality of *n* heat sink elements 7 are present, each of the plurality of *n* heat sink elements 7 being in thermal contact with an associated one of the plurality of *n* thermoelectric assemblies 6. Note that in the exemplary embodiment shown in Fig. 1-5, the value of *n* is four, resulting in a four sided structure of the apparatus 1. As alternative embodiments, *n* could be three (triangular shape), five (pentagonal shape), six (hexagonal shape) or even higher. Note that *n* can even be two or even one, meaning that (a) thermoelectric assembl(y)(ies) 6 and associated contact surface(s) 5 and heat sink element(s) 7 are provided at two sides or one side of the converter block 3.

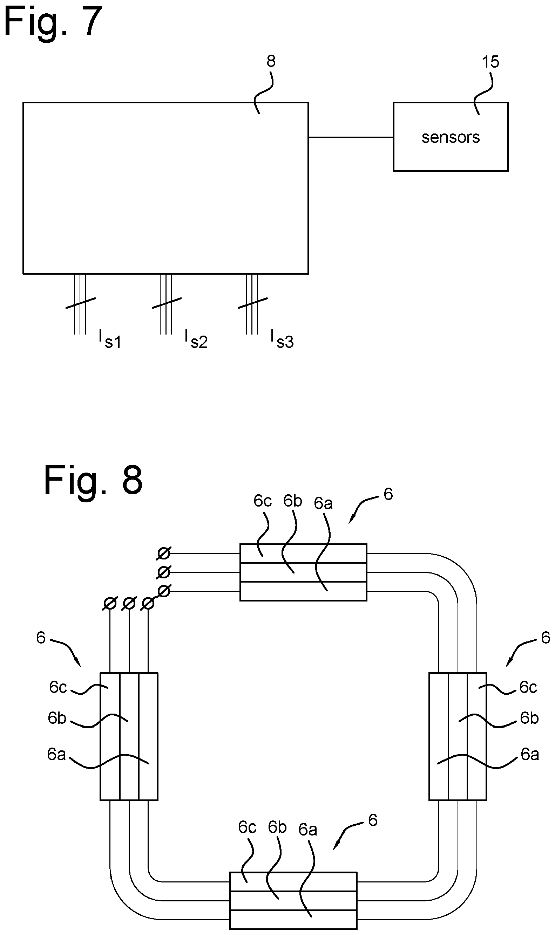

As shown more clearly in the schematic view of Fig. 8, each thermoelectric assembly 6 comprises a stack of *m* thermoelectric heat transfer elements 6a; 6b; 6c, m being equal to two or more, and equal to three in the exemplary embodiment shown.

The apparatus further comprises a control unit 8 for providing current control to the plurality of n thermoelectric assemblies 6. Fig. 7 shows a schematic diagram of such a control unit 8 of an apparatus according to a further embodiment of the present invention.

In the present invention embodiment, the thermoelectric heat transfer elements 6a; 6b; 6c in a corresponding layer in the stacks of the n thermoelectric assemblies 6 are series connected, in effect providing groups of thermoelectric heat transfer elements that can be controlled as a single group. The control unit 8 is furthermore arranged to provide a current control to each of the series connected thermoelectric heat transfer elements 6a; 6b; 6c to obtain a predetermined temperature difference for each of the layers in the stacks of the *n* thermoelectric assemblies 6. By controlling the current supply to the thermoelectric heat transfer elements 6a; 6b; 6c layer by layer using the control unit 8 (see also Fig. 8), a very effective heat exchange can be accomplished in the n stacks from the heat sink elements 7 to the converter block 3 and to a fluid flowing in the channel assembly 4 by optimizing the current to each group of thermoelectric heat transfer elements 6a; 6b; 6c.

In a further embodiment of the present invention apparatus 1, the converter block 3 is divided in two block halves 3a, 3b (see the cross sectional views of Fig. 3-5, and the perspective views of Fig. 6A and 6B) in the direction from fluid input 2a to fluid output 2b, and the contact surfaces 5 are at an angle of 45 degrees to connecting surfaces of the two block halves 3a, 3b. This allows for an easier and more efficient assembly, and a better fit between contact surface 5 and thermoelectric assembly 6, as all the contact surfaces 5 are part of one of the block halves 3a, 3b. Using mating extensions 12 on both block halves 3a, 3b, and optionally (a) further sealing element(s), the channel assembly 4 can be made fluid tight.

The converter block halves 3a, 3b are e.g. provided with assembly extensions 11, allowing efficient assembly of the apparatus 1. The assembly extensions 11 (see Fig. 6A and 6B) e.g. comprise internal threads 11a in a direction perpendicular to the contact surfaces 5, allowing to efficiently mount the (optional) isolation layers 9 and heat sink elements 7 to the convertor block 3 with a bolt 11b via associated mounting apertures 9a, 7a (see specifically the cross sectional view of Fig. 4).

Even if the converter block 3 is made up of two block halves 3a, 3b, it is possible to provide te channel arrangement 4 in an effective manner. In a further embodiment, the fluid channel arrangement 4 comprises a fluid channel in a meander pattern within an internal volume of the converter block 3. The meander pattern provided for a high contact surface of a fluid flowing through the channel assembly 4 during operation, providing for an efficient thermal energy transfer. The meandering pattern of channel assembly 4 is best visible in the bottom perspective view of block half 3a as shown in Fig. 6B. Also the cross sectional views of Fig. 4 and 5 show the channel assembly 4 at different positions along a longitudinal direction of the converter block 3.

In an exemplary embodiment, the fluid channel has a maximum diameter of less than 10mm² over the entire length thereof. In the exemplary embodiment shown, the cross section of the fluid channel is an elongated rectangular surface, further increasing the contact surface thereof. This allows for a sufficiently large contact surface for transfer of thermal energy, yet also provided for a sufficiently low flow resistance to a fluid flowing from fluid input 2a to fluid output 4.

The thermo-electric heat transfer elements 6a; 6b; 6c use the physical effect of thermo-electric cooling (TEC) to displace thermal energy from one of its sides to the other side. Thermo-electric cooling is e.g. implemented as a solid-state method of heat transfer through dissimilar semiconductor materials. Like conventional refrigeration counterparts, thermo-electric cooling systems obey the basic laws of thermodynamics. However, the actual physical phenomenon responsible for cooling is different, i.e. the three main working parts in a thermo-electric refrigeration system are a cold junction, a heat sink, and a DC power source. Two dissimilar semiconductors replace the refrigerant in both liquid and vapour form of a conventional refrigeration system. A cold sink (equivalent to the evaporator surface) becomes cold through absorption of energy by the electrons as they pass from one semiconductor to the other, instead of energy absorption by the refrigerant as it changes from liquid to vapour. A DC power source pumps the electrons from one semiconductor to the other, and the heat sink (equivalent to the condenser surface) discharges the accumulated heat energy from the system. Therefore, the thermo-electric cooling system refrigerates without refrigerant and without the use of mechanical devices. It is noted that the transport of thermal energy can also be used in the 'opposite' direction, i.e. for heating purposes.

The person skilled in the art will be familiar with the specific types of semiconductor materials and structures to be used for implementation of the thermo-electric heat transfer elements 6a; 6b; 6c in the embodiments of the present invention. One of possible implementations, is wherein the thermo-electric heat transfer element 6a; 6b; 6c comprise a Peltier element. In an exemplary implementation of a Peltier element, two (ceramic) isolation plates are present with bars of semiconducting material in between and a specific electrical connection scheme between the bars, i.e. oppositely doped and series connected. When a current source is connected, a current will flow, wherein electrons can only pass through the semiconducting material in one direction. As a result energy is transported in one direction as well, wherein the side of the Peltier element where the electrons originate will become colder, and the side to which the electrons move, will become warmer, or in other words, heat energy is pumped or transferred from one side of the Peltier element to the other.

In the exemplary embodiment of the apparatus 1 as shown in Fig. 1-6B, the dimensions of the Peltier element are less than 40x40mm. This dimension of the Peltier element allows for an efficient operation in the set-up according to the present invention embodiments.

As mentioned above, the control unit 8 may be arranged to provide control currents to the thermoelectric heat transfer elements 6a; 6b; 6c, and may be further arranged to digitally control the control currents, allowing precise control of the operation of the apparatus 1. The control unit 8 may be further arranged to obtain further data allowing to control the apparatus 1 depending on specific circumstances or user needs.

An important operational parameter of the apparatus 1 of the present invention is the coefficient of performance (COP) in transferring thermal energy to a fluid flowing in the channel assembly 4 during operation. For this, also the COP of the thermoelectric heat transfer elements 6a; 6b; 6c is very relevant, i.e. between the hot and cold side of each element. The COP in general is given by the equation Ymax= Th/(Th - Tc), wherein Ymax is the maximum COP for a heat transfer subsystem, and Th and Tc are the temperatures at the hot side and the cold side of the subsystem, in this case each thermoelectric heat transfer element 6a; 6b; 6c. In other words, the smaller the temperature difference between hot and cold side of each element 6a; 6b; 6b, the higher the COP can be.

In the present invention embodiments, stacks of thermoelectric heat transfer elements 6a; 6b; 6c are applied, in effect allowing to use smaller temperature differences for each thermoelectric heat transfer element in a stack, allowing each thermoelectric heat transfer element 6a; 6b; 6c to operate in a more efficient manner. Peltier elements available on the market are designed to provide a maximum obtainable temperature difference between the hot and cold side of 68-72°K.

In the present invention, in a further embodiment the predetermined temperature difference is less than 10% of a maximum obtainable temperature difference of the associated thermoelectric heat transfer elements 6a; 6b; 6c. This allows to obtain a good COP per thermoelectric heat transfer element 6a; 6b; 6c, and hence for each thermoelectric heat transfer assembly 6 and the apparatus 1 as a whole.

In a further embodiment, the predetermined temperature difference is less than 10°K. This allows to obtain operation of the apparatus 1 around an optimum COP, the temperature difference obtained by the stack is then *m**10°K. In an even further optimized embodiments, the predetermined temperature difference is less than 8°K, e.g. 6°K.

In the exemplary embodiment shown in Fig. 1-5, the apparatus furthermore comprises three (more generic: two or more) sequential stages 1ₛ₁-1ₛ₃, each of the two or more stages 1ₛ₁-1ₛ₃ comprising the converter block 3, associated thermoelectric assemblies 6 and associated heat sink elements 7. This allows to obtain a staggered increase in temperature in each stage 1ₛ₁-1ₛ₃ from fluid input 2a to fluid output 2b, which further enhances the efficiency and optimisation achievable by the entire system by obtaining a high temperature difference between fluid input 2a and fluid output 2b..

The control unit 8 may then be arranged to control supply current Iₛ₁-Iₛ₃ to the thermoelectric assemblies 6 associated with each of the two or more sequential stages 1ₛ₁-1ₛ₃, as shown in the schematic diagram of Fig. 7. The desired delta temperature from fluid input 2a to fluid output 2b can be equally divided over the three stages, allowing the thermoelectric assemblies 6 to operate even more efficiently.

In the embodiment shown in Fig. 1-5, the converter blocks 3 of the two or more sequential stages 1ₛ₁-1ₛ₃ are provided as a single converter block, e.g. implemented as one block of aluminium, wherein the channel assembly 4 is a single channel assembly 4 from fluid input 2a to fluid output 2b.

In an advantageous embodiment, the converter block 3 has a generally rectangular (or even square) cross section, and *n* is equal to four. This provides an optimal structure of the stages 1ₛ₁-1ₛ₃ and the entire apparatus 1, e.g. efficiently allowing attachment of the heat sink elements 7.

In the schematic diagram shown in Fig. 7, the control unit 8 is also connected to one or more sensors 15, e.g. temperature sensors positioned at various positions within the apparatus 1. The control unit 8 can then be arranged to implement feedback loops for controlling the current supply 1ₛ₁-1ₛ₃ to each of the stages 1ₛ₁-1ₛ₃. In addition, the sensors 15 may comprise pressure of flow sensors, allowing to further enhance operational control of the apparatus 1 by the control unit 8.

With respect to material used for the various components of the apparatus 1, various selections can be made in view of trade off of efficiency and costs. E.g. the material of the convertor block 3 may be aluminium, but any high thermal conducting material will also be possible, such as silver, gold or copper. As mentioned above, the thermal heat transfer element 6a; 6b; 6c can be Peltier elements, of which the major surface area can be matched with the contact surfaces 5 of the convertor block 3.

In an even further embodiment, the apparatus 1 may further comprising an isolation layer 9 surrounding the converter block 3, the isolation layer 9 comprising an aperture 9b aligned with each of the plurality of *n* thermoelectric assemblies 6. The isolation layer 9 in the exemplary embodiment shown in Fig. 1-5 is a rectangular plate provided with suitable apertures 9b, providing a general box-like structure to the apparatus 1, and allowing to properly attach the heat sink elements 7 on the outside of the apparatus 1 and to the thermoelectric heat transfer assemblies 6. The isolation layer 9 is e.g. made from the reflection material, e.g. having a heat reflection and/or isolation functionality.

Alternatively or additionally, rectangular frame parts 10 may be provided, acting as a shell protection to the isolation layers 9. The frame parts 10 can also act as reflector, e.g. when made from reflection material comprising one or more layers of polyethylene material (with isolation functionality) with a metal layer (e.g. aluminium) deposited on each of the one or more layers of polyethylene material (having a reflection functionality). The combination of reflection material and isolating layers in between provide for a very efficient separation of cold and warm areas in the apparatus 1.

To further enhance the efficiency of the apparatus 1, heat energy retention material is positioned around the convertor block 3, e.g. in the space between convertor block 3 and isolation layers 9 in the embodiment shown in Fig. 1-5. The heat energy retention material is e.g. a moulding material (which can be easily applied in the spaces between the channels 5), or additionally or alternatively, is a stone like material having a high thermal energy retention capacity.

In even further embodiments, each of the plurality of n heat sink elements 7 comprises a cooling fin assembly. This allows for an efficient exchange of heat energy from the environment of the apparatus 1 to the thermoelectric heat transfer assemblies 6, and eventually to a fluid flowing in the channel assembly 4 during operation.

The apparatus 1 in the exemplary embodiment shown in the attached drawings thus comprises three stages 1ₛ₁-1ₛ₃, each comprising four thermoelectric assemblies 6 with a stack of three thermoelectric heat transfer elements 6a; 6b; 6c, thus in total 36 thermoelectric heat transfer (Peltier) elements 6a; 6b; 6c are present. The thermoelectric heat transfer elements 6a; 6b; 6c are controlled by the control unit 8 to operate with a small temperature difference each, providing a high coefficient of performance. Furthermore, the structure of the apparatus 1 as described provided for a very compact assembly, with efficient use of space and materials.

The present invention has been described above with reference to a number of exemplary embodiments as shown in the drawings. Modifications and alternative implementations of some parts or elements are possible. The scope of the invention is defined in the appended claims.

## Claims

1. An apparatus for transferring thermal energy to a fluid, comprising a fluid inlet (2a) and a fluid outlet (2b), a fluid channel arrangement (4) in fluid communication with the fluid inlet (2a) and the fluid outlet (2b), a plurality of n thermoelectric assemblies (6) and a control unit (8) for providing current control to the plurality of n thermoelectric assemblies (6), **characterised by** a converter block (3) having the fluid channel arrangement (4),
the converter block (3) comprising a plurality of n contact surfaces (5),
each of the plurality of *n* thermoelectric assemblies (6) being in thermal contact with an associated one of the plurality of *n* contact surfaces (5),
a plurality of *n* heat sink elements (7), each of the plurality of *n* heat sink elements (7) being in thermal contact with an associated one of the plurality of *n* thermoelectric assemblies (6),
wherein each thermoelectric assembly (6) comprises a stack of m thermoelectric heat transfer elements (6a; 6b; 6c), *m* being equal to two or more,
wherein thermoelectric heat transfer elements (6a; 6b; 6c) in a corresponding layer in the stacks of the *n* thermoelectric assemblies (6) are series connected, and the control unit (8) is arranged to provide a current control to each of the series connected thermoelectric heat transfer elements (6a; 6b; 6c) to obtain a predetermined temperature difference for each of the layers in the stacks of the n thermoelectric assemblies (6).

2. The apparatus according to claim 1, wherein the predetermined temperature difference is less than 10% of a maximum obtainable temperature difference of the associated thermoelectric heat transfer elements (6a; 6b; 6c).

3. The apparatus according to claim 1, wherein the predetermined temperature difference is less than 10°K.

4. The apparatus according to claim 1, wherein the predetermined temperature difference is less than 8°K, e.g. 6°K.

5. The apparatus according to any one of claims 1-4, the apparatus comprising two or more sequential stages (1ₛ₁-1ₛ₃), each of the two or more stages (1ₛ₁-1ₛ₃) comprising the converter block (3), associated thermoelectric assemblies (6) and associated heat sink elements (7).

6. The apparatus according to claim 5, wherein the control unit (8) is arranged to control supply current to the thermoelectric assemblies (6) associated with each of the two or more sequential stages (1ₛ₁-1ₛ₃).

7. The apparatus according to claim 5 or 6, wherein the converter blocks (3) of the two or more sequential stages (1ₛ₁-1ₛ₃) are provided as a single converter block (3).

8. The apparatus according to any one of claims 1-7, wherein the converter block (3) has a rectangular cross section, and *n* is equal to four.

9. The apparatus according to any one of claims 1-8, wherein the thermoelectric heat transfer element (6a; 6b; 6c) comprises a Peltier element.

10. The apparatus according to claim 9, wherein the dimensions of the Peltier element are less than 40x40mm.

11. The apparatus according to any one of claims 1-10, wherein the converter block (3) is divided in two block halves (3a, 3b) in the direction from fluid input (2a) to fluid output (2b), and wherein the contact surfaces (5) are at an angle of 45 degrees to connecting surfaces of the two block halves (3a, 3b).

12. The apparatus according to any one of claims 1-11, wherein the fluid channel arrangement (4) comprises a fluid channel in a meander pattern within an internal volume of the converter block (3).

13. The apparatus according to any one of claims 1-12, wherein the fluid channel has a maximum diameter of less than 10mm² over the entire length thereof.

14. The apparatus according to any one of claims 1-13, further comprising an isolation layer (9) surrounding the converter block (3), the isolation layer (9) comprising an aperture (9a) aligned with each of the plurality of n thermoelectric assemblies (6).

15. The apparatus according to any one of claims 1-14, wherein each of the plurality of *n* heat sink elements (7) comprises a cooling fin assembly.

## Patentansprüche

1. Vorrichtung zum Übertragen von Wärmeenergie auf ein Fluid, die einen Fluideinlass (2a) und einen Fluidauslass (2b), eine Fluidkanalanordnung (4) in Fluidverbindung mit dem Fluideinlass (2a) und dem Fluidauslass (2b), eine Vielzahl von n thermoelektrischen Anordnungen (6) und eine Steuereinheit (8) zum Bereitstellen einer Stromsteuerung für die Vielzahl von n thermoelektrischen Anordnungen (6) umfasst, **gekennzeichnet durch**
einen Wandlerblock (3) mit der Fluidkanalanordnung (4),
wobei der Wandlerblock (3) eine Vielzahl von n Kontaktflächen (5) umfasst,
wobei jede der Vielzahl von *n* thermoelektrischen Anordnungen (6) in thermischem Kontakt mit einer assoziierten der Vielzahl von *n* Kontaktflächen (5) steht,
eine Vielzahl von *n* Wärmesenkelementen (7), wobei jedes der Vielzahl von *n* Wärmesenkelementen (7) in thermischem Kontakt mit einer assoziierten der Vielzahl von *n* thermoelektrischen Anordnungen (6) steht,
wobei jede thermoelektrische Anordnung (6) einen Stapel von *m* thermoelektrischen Wärmeübertragungselementen (6a; 6b; 6c) umfasst, wobei *m* gleich zwei oder mehr ist,
wobei thermoelektrische Wärmeübertragungselemente (6a; 6b; 6c) in einer entsprechenden Schicht in den Stapeln der *n* thermoelektrischen Anordnungen (6) in Reihe geschaltet sind und die Steuereinheit (8) so angeordnet ist, dass sie eine Stromsteuerung für jedes der in Reihe geschalteten thermoelektrischen Wärmeübertragungselemente (6a; 6b; 6c) bereitstellt, um eine vorbestimmte Temperaturdifferenz für jede der Schichten in den Stapeln der n thermoelektrischen Anordnungen (6) zu erhalten.

2. Vorrichtung nach Anspruch 1, wobei die vorbestimmte Temperaturdifferenz weniger als 10 % einer maximal erreichbaren Temperaturdifferenz der assoziierten thermoelektrischen Wärmeübertragungselemente (6a; 6b; 6c) beträgt.

3. Vorrichtung nach Anspruch 1, wobei die vorbestimmte Temperaturdifferenz weniger als 10 °K beträgt.

4. Vorrichtung nach Anspruch 1, wobei die vorbestimmte Temperaturdifferenz weniger als 8 °K beträgt, z.B. 6 °K.

5. Vorrichtung nach einem der Ansprüche 1-4, wobei die Vorrichtung zwei oder mehr sequentielle Stufen (1ₛ₁-1ₛ₃) umfasst, wobei jede der zwei oder mehr Stufen (1ₛ₁-1ₛ₃) den Wandlerblock (3), assoziierte thermoelektrische Anordnungen (6) und assoziierte Wärmesenkelemente (7) umfasst.

6. Vorrichtung nach Anspruch 5, wobei die Steuereinheit (8) so angeordnet ist, dass sie den Versorgungsstrom für die thermoelektrischen Anordnungen (6) steuert, die mit jeder der zwei oder mehr sequentiellen Stufen (1ₛ₁-1ₛ₃) assoziiert sind.

7. Vorrichtung nach Anspruch 5 oder 6, wobei die Wandlerblöcke (3) der zwei oder mehr sequentiellen Stufen (1ₛ₁-1ₛ₃) als ein einziger Wandlerblock (3) bereitgestellt werden.

8. Vorrichtung nach einem der Ansprüche 1-7, wobei der Wandlerblock (3) einen rechteckigen Querschnitt aufweist und n gleich vier ist.

9. Vorrichtung nach einem der Ansprüche 1-8, wobei das thermoelektrische Wärmeübertragungselement (6a; 6b; 6c) ein Peltier-Element umfasst.

10. Vorrichtung nach Anspruch 9, wobei die Abmessungen des Peltier-Elements weniger als 40x40 mm betragen.

11. Vorrichtung nach einem der Ansprüche 1-10, wobei der Wandlerblock (3) in der Richtung von dem Fluideinlass (2a) zu dem Fluidauslass (2b) in zwei Blockhälften (3a, 3b) unterteilt ist und wobei die Kontaktflächen (5) in einem Winkel von 45 Grad zu den Verbindungsflächen der beiden Blockhälften (3a, 3b) stehen.

12. Vorrichtung nach einem der Ansprüche 1-11, wobei die Fluidkanalanordnung (4) einen Fluidkanal in einem Mäandermuster innerhalb eines Innenvolumens des Wandlerblocks (3) umfasst.

13. Vorrichtung nach einem der Ansprüche 1-12, wobei der Fluidkanal über seine gesamte Länge einen maximalen Durchmesser von weniger als 10 mm² aufweist.

14. Vorrichtung nach einem der Ansprüche 1-13, die ferner eine Isolationsschicht (9) umfasst, die den Wandlerblock (3) umgibt, wobei die Isolationsschicht (9) eine Öffnung (9a) umfasst, die mit jeder der Vielzahl von n thermoelektrischen Anordnungen (6) ausgerichtet ist.

15. Vorrichtung nach einem der Ansprüche 1-14, wobei jedes der Vielzahl von *n* Wärmesenkelementen (7) eine Kühlrippenanordnung umfasst.

## Revendications

1. Appareil pour transférer de l'énergie thermique à un fluide, comprenant une entrée de fluide (2a) et une sortie de fluide (2b), un agencement de canal de fluide (4) en communication fluidique avec l'entrée de fluide (2a) et la sortie de fluide (2b), une pluralité de *n* ensembles thermoélectriques (6) et une unité de contrôle (8) pour fournir un contrôle de courant à la pluralité de *n* ensembles thermoélectriques (6), **caractérisé par**
un bloc convertisseur (3) ayant l'agencement de canal de fluide (4),
le bloc convertisseur (3) comprenant une pluralité de *n* surfaces de contact (5),
chacun de la pluralité de *n* ensembles thermoélectriques (6) étant en contact thermique avec une surface de contact associée de la pluralité de *n* surfaces de contact (5), une pluralité de *n* éléments de dissipateur thermique (7), chacun de la pluralité de *n* éléments de dissipateur thermique (7) étant en contact thermique avec un ensemble thermoélectrique associé de la pluralité de *n* ensembles thermoélectriques (6), où chaque ensemble thermoélectrique (6) comprend un empilement de *m* éléments de transfert de chaleur thermoélectriques (6a ; 6b ; 6c), *m* étant égal à deux ou plus,
où des éléments de transfert de chaleur thermoélectriques (6a ; 6b ; 6c) dans une couche correspondante dans les empilements des *n* ensembles thermoélectriques (6) sont connectés en série, et l'unité de contrôle (8) est disposée pour fournir un contrôle de courant à chacun des éléments de transfert de chaleur thermoélectriques connectés en série (6a; 6b; 6c) pour obtenir une différence de température prédéterminée pour chacune des couches dans les empilements des *n* ensembles thermoélectriques (6).

2. Appareil selon la revendication 1, où la différence de température prédéterminée est inférieure à 10 % d'une différence de température maximale pouvant être obtenue des éléments de transfert de chaleur thermoélectriques associés (6a; 6b; 6c).

3. Appareil selon la revendication 1, où la différence de température prédéterminée est inférieure à 10°K.

4. Appareil selon la revendication 1, où la différence de température prédéterminée est inférieure à 8°K, par ex. 6°K.

5. Appareil selon l'une quelconque des revendications 1 à 4, l'appareil comprenant deux ou plusieurs étages séquentiels (1ₛ₁-1ₛ₃), chacun des deux ou plusieurs étages (1ₛ₁-1ₛ₃) comprenant le bloc convertisseur (3), des ensembles thermoélectriques associés (6) et des éléments dissipateurs thermiques associés (7).

6. Appareil selon la revendication 5, où l'unité de commande (8) est disposée pour contrôler le courant d'alimentation des ensembles thermoélectriques (6) associés à chacun des deux ou plusieurs étages séquentiels (1ₛ₁-1ₛ₃).

7. Appareil selon la revendication 5 ou 6, où les blocs convertisseurs (3) des deux ou plusieurs étages séquentiels (1ₛ₁-1ₛ₃) sont fournis comme un bloc convertisseur unique (3).

8. Appareil selon l'une quelconque des revendications 1 à 7, où le bloc convertisseur (3) a une section transversale rectangulaire et *n* est égal à quatre.

9. Appareil selon l'une quelconque des revendications 1 à 8, où l'élément de transfert de chaleur thermoélectrique (6a; 6b; 6c) comprend un élément Peltier.

10. Appareil selon la revendication 9, où les dimensions de l'élément Peltier sont inférieures à 40x40 mm.

11. Appareil selon l'une quelconque des revendications 1 à 10, où le bloc convertisseur (3) est divisé en deux moitiés de bloc (3a, 3b) dans la direction de l'entrée de fluide (2a) à la sortie de fluide (2b), et où les surfaces de contact (5) forment un angle de 45 degrés par rapport aux surfaces de connexion des deux moitiés de bloc (3a, 3b).

12. Appareil selon l'une quelconque des revendications 1 à 11, où l'agencement de canal de fluide (4) comprend un canal de fluide selon un motif en méandre à l'intérieur d'un volume interne du bloc convertisseur (3).

13. Appareil selon l'une quelconque des revendications 1 à 12, où le canal de fluide a un diamètre maximum inférieur à 10 mm² sur toute sa longueur.

14. Appareil selon l'une quelconque des revendications 1 à 13, comprenant en outre une couche d'isolation (9) entourant le bloc convertisseur (3), la couche d'isolation (9) comprenant une ouverture (9a) alignée avec chacun de la pluralité de n ensembles thermoélectriques (6).

15. Appareil selon l'une quelconque des revendications 1 à 14, où chacun de la pluralité de *n* éléments de dissipateur thermique (7) comprend un ensemble d'ailettes de refroidissement.
